# EUROPÄISCHE PATENTANMELDUNG

(11) **EP 4 461 452 A2**
(43) Veröffentlichungstag der Anmeldung: **13.11.2024**
(21) Anmeldenummer: 24174967.0
(22) Anmeldetag: 08.05.2024
(51) Int. Cl.: B23K 3/08, H05K 13/00

(54) **WERKSTÜCKTRÄGER**

(30) Priorität: 08.05.2023 DE 102023111995
(71) Anmelder: SEHO Vermögensverwaltungs GmbH & Co. KG, 97892 Kreuzwertheim (DE)
(72) Erfinder: Reinhardt, Andreas, 97072 Würzburg (DE); Huth, Andreas, 97892 Kreuzwertheim-Röttbach (DE); Herz, Thomas, 97892 Kreuzwertheim (DE); Walter, Markus, 97877 Wertheim-Vockenrot (DE); Winkler, Daniel, 63897 Miltenberg (DE)
(74) Vertreter: HGF

(57) **Zusammenfassung**

Die Erfindung betrifft einen Werkstückträger (1) zur Positionierung von Werkstücken auf einer Transporteinrichtung in einer Lötmaschine. Der Werkstückträger weist einen Körper (2) aus einem temperatursteifen Kunststoff auf. Der Körper (2) des Werksstückträgers (1) ist mittels einem additiven Fertigungsverfahren hergestellt und der Werkstückträger (1) weist eine Wärmestrahlung reflektierende Beschichtung (4) auf.

## Beschreibung

Die Erfindung betrifft einen Werkstückträger zum Transport von Werkstücken im Zusammenhang mit Lötvorgängen.

Werkstücke, oder auch Baugruppen genannt, bestehen zumeist aus einer Platine, die mit Bauteilen bestückt ist. Um diese Bauteile fest und elektrisch leitend mit der Platine zu verbinden, werden diese üblicherweise verlötet.

Werkstückträger werden bei Lötvorgängen eingesetzt, um eine Anpassung einer Baugruppe an die Transportbreite einer Anlage zu erreichen, einen Transport zu ermöglichen oder auch durch die Fixierung einzelner Bauteile zum Schutz gegen ein Herausfallen oder Verschieben zu bieten. Gleichzeitig werden oft sensible Bereiche der Baugruppe durch den Werkstückträger oder daran zusätzlich angebrachte Elemente abgedeckt, um diese vor Einflüssen während des Lötvorgangs zu schützen. Diese zusätzlichen Elemente bilden Barrieren gegen Wärmestrahlung, Berührung oder Flussmittel.

Diese Werkstückträger unterliegen im Prozess einem Kreislauf, d.h. die Baugruppe wird unprozessiert in den Werkstückträger eingelegt, durchläuft den Prozess, wird fertig prozessiert entnommen und der Werkstückträger wird für die nächste Baugruppe verwendet. Üblicherweise befindet sich eine Vielzahl gleichartiger Werkstückträger gleichzeitig in einer Lötmaschine, um eine ausreichende Auslastung zu erreichen. Der Werkstückträger, oder im Folgenden auch Träger genannt, kann während des Lötvorgangs bestimmte Schritte, wie Flussmittelauftrag und/oder Vorheizen und/oder Benetzen und/oder Abkühlen, durchlaufen. Jedoch kann es sich auch um nicht mit dem Lötvorgang verknüpfte Schritte außerhalb der Lötmaschine handeln, wie Nutzentrennen, Fräsen, Lackieren, Aushärten, Einpress - oder Schraubverfahren, elektrische/mechanische/optische/Röntgen- Prüfungen und/oder Reinigungsverfahren.

Die Erfordernis, dass ein Werkstückträger bei Lötvorgängen oftmals zusammen mit dem Werkstück den Aufheiz-, den Löt- und den Abkühlprozess durchlaufen muss, führt dazu, dass der Werkstückträger wiederholten Temperaturschwankungen ausgesetzt ist. Durch die starke Belastung verändern sich die Materialeigenschaften des Werkstückträgerkörpers. Bspw. kann der Werkstückträger nach mehreren tausend Lötvorgängen unbrauchbar werden. Eine Nachbehandlung mit Reinigungsmitteln, um Rückstände zu entfernen, kann sich ebenfalls verkürzend auf die Lebensdauer auswirken.

Solche Werkstückträger sollen sich nicht verformen, auch wenn sie erheblichen Temperaturschwankungen unterliegen. Herkömmliche Werkstückträger weisen Körper auf, die bspw. aus Aluminium oder aus einem duroplastischen Faserverbundwerkstoff ausgebildet sind, um die notwendige Temperaturstabilität sicherzustellen.

Die Werkstückträger werden aus Platten bspw. durch Schneiden und/oder Fräsen hergestellt, sodass sie eine zur Aufnahme der Baugruppe geeignete komplementäre Form besitzen.

Die Körper können individuell auf Werkstücke angepasst werden. Die Materialien der Körper sind im Fall von elektronischen Werkstücken vorzugsweise ableitfähig gegenüber elektrostatischer Aufladung.

Die US 2022/0045467 A1 betrifft eine Haltevorrichtung, um zwei elektrische Komponenten derart zusammenzuhalten, dass sie einen Kontakt oder nahezu Kontakt untereinander für einen Lötvorgang ausbilden. Die elektrischen Komponenten werden mittels Federklemmen in Position gehalten. Die Haltevorrichtung ist zum manuellen Löten ausgebildet. Die Haltevorrichtung kann mittels 3D-Druck hergestellt werden.

Aus der DE 695 14 895 T2 geht ein Verfahren zur Montage eines Anschlusses an eine flexible gedruckte Leiterplatte hervor. Zunächst wird ein wärmeisolierender Halter mit der flexiblen gedruckten Leiterplatte kontaktiert, sodass sich ein Lötauge der flexiblen Leiterplatte und der Anschluss innerhalb einer Öffnung des wärmeisolierenden Halters befinden. Das Lot gelangt durch einen Fließ- oder Aufschmelz-Lötprozess in die Öffnung und der Anschluss wird mit dem Lötauge verlötet.

Die US 5,060,846 A zeigt ein Gerät zur Positionierung von multiplanaren oder mehradrigen elektronischen Surface-Mount-Bauteilen (SMD) auf einer Leiterplatte während eines Reflow-Lötprozesses. Die Vorrichtung aus thermoplastischen Harzen wird dazu verwendet, die relative Position des SMD-Bauteils auf der Leiterplatte während des Prozesses aufrechtzuerhalten.

Die CN 210548716 U betrifft einen Linearverschiebungsmechanismus für den Gebrauch beim Lötvorgang. Das Werkstück wird in eine Halterung eingesetzt und ein oberer Teil der Halterung weist Lagen zur Temperaturkontrolle und zur Hitzeverteilung auf.

Aus der JP H 05218632 A geht eine Vorrichtung hervor, um eine flexible Leiterplatte vor dem Erweichen an einem kritischen Temperaturpunkt während eines Lötprozesses zu schützen.

Der vorliegenden Erfindung liegt die Aufgabe zugrunde, einen Werkstückträger mit langer Lebensdauer zu schaffen.

Eine weitere Aufgabe der Erfindung ist es, einen Werkstückträger zu schaffen, der einfach und kostengünstig herstellbar ist und dennoch sehr widerstandsfähig gegenüber den bei Lötvorgängen auftretenden thermischen Belastungen ist und eine im Vergleich zum Stand der Technik energiesparendere Prozessierung von Baugruppen ermöglicht.

Eine oder mehrere Aufgaben werden durch die Gegenstände der unabhängigen Ansprüche 1 und/oder 2 gelöst. Vorteilhafte Ausgestaltungen der Erfindung sind in den jeweiligen Unteransprüchen angegeben.

Ein erfindungsgemäßer Werkstückträger zur Positionierung von Werkstücken auf einer Transporteinrichtung in einer Lötmaschine weist einen Körper aus einem insbesondere temperatursteifem Kunststoff auf und zeichnet sich durch Herstellung mittels einem additiven Fertigungsverfahren und durch eine Wärmestrahlung reflektierende Beschichtung aus.

Eine Lötmaschine für Schwall- oder Wellenlöten kann einen Löttunnel aufweisen, in dem eine Transporteinrichtung angeordnet ist, mit welcher zu lötende Baugruppen in einem Werkstückträger in Transportrichtung prozessiert werden können. Die Lötmaschine ist zumeist etwa horizontal liegend ausgebildet und weist üblicherweise einen Ketten- oder Riemenantrieb auf. Die Ketten bzw. Riemen sind in einem bestimmten Abstand zueinander angeordnet. Der Werkstückträger wird derart positioniert, dass der Werkstückträger auf den Ketten bzw. Riemen aufliegt und so durch den Löttunnel transportiert werden kann. Die Lötmaschine kann anstelle eines Löttunnels bspw. einen Drehtisch mit Rahmen aufweisen, in welchen die Werkstückträger eingesetzt werden. Der Werkstückträger ist also gemäß den durch die Lötmaschine bzw. den Löttunnel vorgegebenen Abmaßen zu dimensionieren. Durch die Verwendung von additiven Fertigungsverfahren bei der Herstellung des Werkstückträgerkörpers sind genaue Anpassungen an die Geometrie und die Abmaße der Lötmaschine als auch der zu lötendenden Baugruppe möglich.

Additive Fertigungsverfahren können im Folgenden auch als 3D-Druck-Verfahren bezeichnet werden.

Mittels 3D-Drucken ist es möglich, verschiedenste dreidimensionale Bauteile mit komplexer Geometrie herzustellen. Somit ist es möglich einen Aufnahmebereich des Werkstückträgers für ein Werkstück auf die genaue Geometrie des Werkstücks auszubilden. Die Kontur des Werkstücks kann demnach auf dem Werkstückträger nachgebildet werden. Dadurch ist das Werkstück im Werkstückträger eindeutig positionierbar.

Aus der Herstellung mittels 3D-Druck ergibt sich auch der Vorteil, dass das Werkstück auf allen Seiten aufliegen kann, wodurch ein Durchbiegen des Werkstücks bspw. einer Leiterplatte verhindert wird.

Weiterhin ist die Kontur des Aufnahmebereichs mittels additiven Fertigungsverfahren derart ausbildbar, dass vorbestimmte Randbereiche des Werkstücks nicht auf dem Werkstückträger aufliegen. Dadurch ist es möglich, dass Werkstücke bspw. Leiterplatten auch in den Randbereichen bestückbar sind.

Durch die Herstellung des Werkstückträgers mittels additiven Fertigungsverfahren können im Werkstückträger einfach Hohlräume ausgebildet werden, mit welchen die Wärmekapazität des Werkstückträgers gering gehalten werden kann.

Dadurch, dass der Werkstückträger eine Wärmestrahlung reflektierende Beschichtung aufweist, wird das Erhitzen des Werkstückträgers erheblich verzögert, sodass sich bei den Lötmaschinen üblichen Durchlaufzeiten der Werkstückträger weniger aufheizt als herkömmliche Werkstückträger. Dies macht es einfacher die Werkstückträger aus Kunststoff auszubilden, da die Temperaturbelastung des Kunststoffes gering gehalten wird. Dadurch wird eine lange Lebensdauer erzielt.

Durch die geringere Wärmekapazität des Werkstückträgers, da er aus Kunststoff gefertigt ist, ist die Wärmeaufnahme des Körpers gering. Beim Abkühlvorgang des Werkstückträgers zur schnelleren Wiederverwendung muss somit weniger Kühlenergie aufgebracht werden. Der Energiebedarf der gesamten Prozessierung des Werkstückträgers wird somit reduziert.

Durch die Herstellung des Werkstückträgers mittels additiver Fertigungsverfahren ist es möglich den Werkstückträger derart auszubilden, dass der Werkstückträger lediglich Material an den Stellen aufweist, wo es für die Funktion des Werkstückträgers essentiell ist. Beispielsweise sind Hohlräume und Aussparungen im Werkstückträger dort vorgesehen, wo die Stabilität und Funktion des Werkstückträgers nicht beeinträchtigt werden. Durch die Schaffung von Hohlräumen und Aussparungen ist die Masse an Kunststoff und die Wärmekapazität des Werkstückträgers im Vergleich zu herkömmlichen Werkstückträgern geringer.

Durch das Vorsehen einer Wärmestrahlung reflektierenden Schicht kann der Körper des Werkstückträgers aus einem Kunststoff ausgebildet sein, der selbst keine sehr hohe Temperaturstabilität aufweist. Es kann bspw. ein thermoplastischer Kunststoff sein, der bspw. mit einem additiven Herstellungsverfahren bearbeitet werden kann.

Beim 3D-Druck werden dreidimensionale Werkstücke schichtweise aufgebaut. Der Aufbau erfolgt computergesteuert aus einem oder mehreren flüssigen oder festen Werkstoffen nach vorgegebenen Maßen und Formen (CAD-Daten). Beim Aufbau finden physikalische oder chemische Härtungs- oder Schmelzprozesse statt.

Die wichtigsten Techniken des 3D-Druckens sind das selektive Laserschmelzen (SLM) bzw. Laser Powder Bed Fusion (LPBF), das Laserauftragschweißen (LA), das selektive Lasersintern (SLS) für Polymere, Keramik und Metalle, Binder- und Material-Jetting (CJP/MJM), Material Extrusion (FDM/FFF) und VAT Polymerisation (DLP/DLS).

Beim selektiven Laser-Sintern (SLS) wird auf einer Arbeitsfläche (Bauplattform) eine Schicht Pulverwerkstoff aufgetragen. Das lose Pulver wird durch einen Laserstrahl punktuell bzw. selektiv aufgeschmolzen. Dabei werden die Pulverpartikel je nach verwendetem Werkstoff in der Schicht und mit der darunterliegenden Schicht verbunden.

Beim Electron Beam-Melting bzw. Elektronenstrahlschmelzen wird, ähnlich wie beim Selective Laser-Melting (SLM) eine hohe Energie eingebracht, die zum Schmelzen des Baumaterials führt. Die Energiezuführung geschieht nicht über einen Hochleistungslaser, sondern über einen starken Elektronenstrahl, der mittels starker Magnetspulen passend abgelenkt und damit positioniert wird. Der Prozess des Electron Beam-Meltings muss unter Hochvakuum ablaufen. Dies begrenzt deutlich den Bauraum der Geräte, die mit dem Selektiven Elektronenstrahlschmelzen arbeiten.

Im Gegensatz zum Selective Laser-Sintering (SLS) wird beim Selective Laser-Melting (SLM) bzw. Selektivem Laserschmelzen über einen Laserstrahl deutlich mehr Energie in das Pulverbett eingebracht, so dass an den betroffenen Stellen eine echte Materialschmelze entsteht. Damit entsteht im Vergleich zum SLS-Verfahren ein homogeneres Objekt mit höherer Dichtheit.

Laserauftragschweißen gehört zum Auftragschweißen (Cladding), bei dem ein Werkstück mittels Aufbringen und gleichzeitigem Aufschmelzen eines nahezu beliebigen Materials erfolgt. Dies kann in Pulverform z. B. Kunststoffpulver geschehen. Beim Laserauftragschweißen dient als Wärmequelle ein Laser hoher Leistung, vornehmlich Diodenlaser oder Faserlaser, früher auch CO2- und Nd:YAG-Laser.

Beim Binder-Jetting (CJM) wird pulverförmiges Ausgangsmaterial durch ein flüssiges Bindemittel aus einem Druckkopf derart verbunden, sodass das Pulver durch das Bindemittel an bestimmten Stellen verklebt wird. Durch verschiedene Kombinationsmöglichkeiten aus Pulver und Bindemittel können verschiedene Materialeigenschaften in ein Teil gedruckt werden.

Beim Material-Jetting (MJM) kann durch den verfahrbaren Druckkopf hohe Genauigkeit und wenig Materialüberstand erreicht werden. Flüssiges Material wird über den Druckkopf schichtweise aufgetragen und durch Licht ausgehärtet.

Im Gegensatz dazu wird bei der Materialextrusion (FDM/FFF) das Material, das sich zuvor auf einer Rolle befunden hat, im Bereich eines/einer Extruders/Düse aufgeschmolzen und flüssig schichtweise aufgetragen. Dieser Prozess ist besonders kostengünstig und bietet die meisten Erfahrungswerte.

Bei der VAT Photopolymerisation befindet sich mit Polymeren angereichertes flüssiges Harz in einem Behältnis. Dieses Harz wird schichtweise durch Licht ausgehärtet. Die VAT Polymerisation zeichnet sich durch hohe Genauigkeit und Schnelligkeit aus.

Durch die Vielzahl an zur Verfügung stehenden 3D-Druckverfahren kann die Materialauswahl für den Werkstückträger abgestimmt werden.

Ein Vorteil von 3D-gedruckten Werkstückträgern gegenüber Werkstückträgern, welche bspw. durch Schneiden und/oder Fräsen hergestellt worden sind, ist, dass keine hohen Anteile an Abfallstoffen anfallen. Zusätzlich können beispielsweise durch das Fräsen von Faserverbundkunststoffen Stäube auftreten, welche gesundheitsschädlich sein können und/oder hohe Arbeitsschutzmaßnahmen erfordern.

Ein weiterer Vorteil der durch 3D-Druck hergestellten Werkstückträger ist die einfache und schnelle mechanische Nachbearbeitbarkeit. Dadurch können Toleranzen aus dem Druck einfach ausgeglichen werden und eine genaue Anpassung an das Werkstück ist möglich.

Die Verwendung von 3D-Druck bietet auch den Vorteil, dass man nicht von einem Grundmaterial, welches in einer vorbestimmten Stärke vorliegt, abhängig ist. Dadurch ist auch die Produktion eines Werkstückträgers unmittelbar nach CAD (Computer-aided Design) - Daten möglich, d. h. es muss kein CNC(Computerized Numerical Control)-Programm für eine Werkzeugmaschine bspw. Fräsmaschine geschrieben werden bevor die Produktion beginnen kann.

Mittels 3D-Druck lassen sich Wabenstrukturen im Körper realisieren, wodurch eine geringe thermische Masse bei hoher Stabilität realisierbar ist.

Die Wärmestrahlung reflektierende Beschichtung kann sich über eine vollständige Oberfläche des Werkstückträgers an einer Seite desselben erstrecken oder auch lediglich partiell aufgetragen sein. Eine partieller Auftrag der Beschichtung ist dann zweckmäßig, wenn bestimmte Abschnitte gegenüber der Wärmequelle stärker als andere Abschnitte exponiert sind und/oder wenn es Abschnitte am Werkstückträger gibt, welche besonders empfindlich gegenüber der Wärmeeinwirkung sind. Dann können diese Abschnitte durch einen partiellen oder bereichsweisen Auftrag der Beschichtung geschützt werden. Der Werkstückträger kann Hinterschnitte oder geschlossene Hohlräume zur Reduzierung der thermischen Masse aufweisen.

Ein Hinterschnitt bei einem solchen Werkstückträger ist eine Ausnehmung bzw. Konturierung, welche dem Werkstückträger eine von einer ebenflächigen Platte abweichende Form verleiht, die nicht durch einen Schnitt senkrecht zur Ebene, in der sich die Platte erstreckt, er-zeugt wird. Bei plattenförmigen Materialien werden solche Konturen durch spanende Bearbeitungen der Platte erreicht, welche nicht eine senkrechte zur Ebene der Platte verlaufende Schnittkante aufweisen. Derartige Schnittkanten werden hinterschnitten. Diese Hinterschnitte können Stufen, offene Hohlräume oder dergleichen am Werkstückträger sein.

Solche Werkstückträger mit komplexen Formen (Hinterschnitte oder geschlossenen Räume) können komplexe Baugruppen zuverlässig aufnehmen oder weitere Funktionen, wie z.B. thermisch isolierende Hohlräume beinhalten. Solche Werkstückträger weisen oftmals in der Draufsicht die Form eines Rahmens mit vier umlaufenden Rahmensegmenten auf.

An einem Randbereich des Werkstückträgers kann eine Leiste zur Positionierung in einer Transporteinrichtung angeordnet sein.

Daraus ergibt sich der Vorteil, dass der Werkstückträger mit der Leiste in ein Transportelement der Lötmaschine wie bspw. in einen Träger einer Transporteinrichtung eingehakt oder direkt auf Ketten, Riemen oder auf einem Drehteller abgelegt werden kann.

Ein temperatursteifer Kunststoff behält seine Form und seine Stabilitätseigenschaften über einen geforderten Temperaturbereich über eine bestimmte Zeitspanne. Ein temperatursteifer Kunststoff für einen Werkstückträger sollte bei einer Temperatur von zumindest 100°C und insbesondere zumindest 120°C bzw. zumindest 130°C für eine Dauer von etwa 30 min seine Stabilitätseigenschaften behalten. Der Glasübergangspunkt des Kunststoffes sollte hierbei möglichst über der geforderten Mindesttemperatur liegen.

Vorzugweise enthält die Beschichtung elektrisch leitende Partikel zur Ableitung elektrostatischer Aufladung.

Um die Funktionalität sensibler elektronischer Bauteile oder Baugruppen beim Transport im Werkstückträger zu erhalten, ist elektrostatische Aufladung zu vermeiden. Eine einfache Möglichkeit sicherzustellen, dass elektrostatische Aufladung vom Werkstück abgeleitet werden kann, ist es die Oberfläche des Werkstückträgers elektrisch leitfähig auszubilden.

In Ausführungsformen können diese Partikel insbesondere Chrom-, Aluminium-, Gold-, Silber-, Nickel- und/oder Kupferpartikel sein. Diese Metalle und Legierungen, in denen sie enthalten sind, zeichnen sich durch ihre Wärmestrahlung reflektierende Wirkung und ihre hohe elektrische Leitfähigkeit aus.

Vorzugsweise umfasst die Beschichtung des Werkstückträgers mehrere Schichten.

Mit Hilfe von mehrschichtiger Auftragung kann sich eine homogenere Oberfläche ausbilden, welche die Wärmestrahlung besser reflektieren kann. Die Auftragungsvorrichtung beispielsweise eine Düse muss weniger gleichmäßig aufspritzen als bei nur einer Schicht. Wenn die Beschichtung Partikel enthält werden diese über mehrere Schichten gleichmäßiger verteilt und bilden eine besser thermisch spiegelnde Oberfläche. Es hat sich auch gezeigt, dass mehrere dünne Schichten bessere Reflexionseigenschaften als eine genauso dicke einzelne Schicht haben. Es wird davon ausgegangen, dass die Metallpartikel, die oftmals plättchenförmig sind, sich in den dünnen Schichten öfters mit ihrer Fläche etwa parallel zur Ebene der jeweiligen Schicht ausrichten und so einen großen Wirkungsquerschnitt bereitstellen.

Vorzugsweise ist der Werkstückträger nach dem Auftragen der Beschichtung getempert worden.

Eine getemperte Beschichtung hat den Vorteil, dass sie mit einer höheren Temperatur als beim Lötvorgang ausgehärtet worden ist. Außerdem ist die Beschichtung durch das Tempern beständiger gegenüber thermischen und chemischen Belastungen.

Dadurch, dass die thermische Masse des Werkstückträgers oftmals die thermische Masse des Werkstücks übersteigt, muss mehr Wärme in den Werkstückträger als in das Werkstück eingebracht werden. Folglich ist die abzuführende Wärmeenergie zur Abkühlung des Werkstückträgers auch entsprechend höher. Die thermische Belastung bei nur einer Prozessierung kann für den Körper größer sein als für das Werkstück selbst. Die Wärmekapazität wird durch Ausnehmungen in Form von Hinterschnitten oder geschlossenen Hohlräumen reduziert, wobei bei der Stabilität des Werkstückträgers keine Abstriche gemacht werden müssen.

Durch die Reduzierung der thermischen Masse bzw. der Wärmekapazität des Körpers kühlt der Körper nach dem Durchlauf durch die Lötmaschine schneller ab als ein herkömmlicher Werkstückträger.. Dadurch können der Körper und das Werkstück schneller weiteren Prozessschritten zugeführt werden, wie z.B. dem Vereinzeln von Werkstückträger und Werkstück, da ein kühlerer Körper besser mit den Händen angefasst werden kann.

Vorzugsweise werden Hinterschnitte oder geschlossene Hohlräume durch additive Fertigungsverfahren ausgebildet. Additive Fertigungsverfahren können im Folgenden auch als 3D-Druck bezeichnet werden.

Durch die Herstellung mittels 3D-Druck können auch weitere Materialien während des Prozesses in den Werkstückträger eingebracht werden bspw. Fasern oder Buchsen, Einlegeteile oder dergleichen.

Mittels der durch die additive Fertigung eingebrachten Hinterschnitte und Hohlräume lässt sich nicht nur die thermische, sondern auch die zu beschleunigende Masse beim Transport verringern. Geringeres Gewicht wirkt sich vorteilhaft auf den Verschleiß der mechanischen Bauteile in einer Transporteinrichtung, wie z.B. einer Lötmaschine, aus.

Durch die Anpassung an die Baugruppe kann ein guter thermischer Kontakt zur Baugruppe hergestellt werden. Damit kann die Wärmeleitung von Baugruppe zum Träger und umgekehrt gezielt erfolgen und negative gegenseitige Beeinflussungen, wie bspw. der Temperaturunterschied zwischen wärmerer Baugruppe und kaltem Träger beim ersten Durchlauf durch die Lötmaschine, werden minimiert.

Ein weiterer Vorteil der genauen Anpassung an das Werkstück ist, dass keine zusätzlichen Federdruckstifte benötigt werden, um die Baugruppe mit der erforderlichen Positionsgenauigkeit zu prozessieren. Sollten dennoch Fixierelemente gegen das Verschieben oder Herausfallen benötigt werden, können federnde Elemente direkt gedruckt werden.

Eine weitere Möglichkeit der additiven Fertigung besteht darin, den Körper in freier Formgebung als verbindbares Teil auszugestalten. So können nach dem Baukastenprinzip verschiedene Werkstückträger mit unterschiedlichen Ausnehmungen für Werkstücke zusammen verbunden prozessiert werden. Man kann die einzelnen Teile je nach Anwendungsfall zusammensetzen und somit die Lötmaschine kostenoptimiert betreiben und stärker auslasten.

Es können auch mehrere Werkstückträger in einem gemeinsamen Rahmen, der bspw. aus Aluminium gefertigt ist, eingesetzt und gemeinsam prozessiert werden. Dies ist zum Löten von kleinen Baugruppen vorteilhaft.

Vorzugsweise werden in die Hinterschnitte oder in die geschlossenen Hohlräume Kanäle zur Durchleitung von einem Kühlmedium eingebracht, damit der Werkstückträger nach dem Lötvorgang aktiv durch Durchleiten eines Kühlmediums gekühlt wird und damit schneller einsatzfähig für die weitere Prozessierung ist. Weiterhin kann in die Kanäle auch ein warmes Medium eingeleitet werden, um den Werkstückträger und auch die Baugruppe schneller für den Lötvorgang vorzuheizen.

Das kalte Medium oder Kühlmedium kann ein Kältemittel in Form eines Fluids, das zur Wärmeaufnahme dient, sein. Das warme Medium kann ein Wärmemittel in Form eines Fluids, das zur Wärmeabgabe dient, sein.

Gemäß einer weiteren Ausführungsform werden in die Hinterschnitte oder geschlossenen Hohlräume Einlegeteile zur Verbesserung der Stabilität des Werkstückträgers eingesetzt. Dadurch lässt sich die Kräfteverteilung im Werkstückträger gezielt und richtungsabhängig beeinflussen und ein Durchbiegen des Werkstückträgers wird verhindert. Diese Einlegeteile können durch die additive Fertigung genau in den Köper eingepasst werden, wodurch keine zusätzlichen Stifte zur Befestigung und/oder Positionierung nötig sind.

Der Körper des Werkstückträgers kann derart ausgebildet sein, dass er aus einem thermoplastischen Kunststoff hergestellt wird, der durch chemische Behandlung und/oder Strahlungseinwirkung in einen duroplastischen Kunststoff umgewandelt wird.

Körper aus duroplastischem Kunststoff weisen zumeist eine höhere Temperaturstabilität und Strapazierbarkeit gegenüber Temperaturschwankungen auf als Körper aus thermoplastischem Kunststoff. Deshalb kann diese Umwandlung von Vorteil sein.

Temperaturstabilität ist vorteilhaft für die Prozessierung von Werkstücken, da sich Verformungen des Werkstückträgers während der Prozessierung negativ auf das Werkstück auswirken können.

Zur Verbesserung der Stabilität, insbesondere der Temperaturstabilität, kann der thermoplastische Kunststoff des Körpers in Ausführungsformen Glas- und/oder Carbonfasern enthalten.

Vorzugsweise liegt der Anteil an Carbonfasern zwischen 10 - 25%, da in diesem Bereich die Carbonfasern zur Verbesserung der Temperaturstabilität beitragen. Ein höherer Anteil an Carbonfasern erhöht auch die thermische Leitfähigkeit des Kunststoffs, sodass sich der Körper während des Lötvorgangs stärker erwärmt und infolgedessen von einer höheren Temperatur wieder abgekühlt werden muss. Der Körper ist in diesem Fall stärkeren Temperaturschwankungen ausgesetzt, was sich verkürzend auf die Lebensdauer des Körpers auswirken kann. Um diesen Effekt gering zu halten, kann es zweckmäßig sein, die Fasern im Werkstückträger etwa parallel zu seiner ebenflächigen Erstreckung anzuordnen. Hierdurch erfolgt ein schneller Wärmeausgleich in der Ebene des Werkstückträgers aber nicht quer dazu.

Im Kunststoff enthaltene Glasfasern sind vorzugsweise lang (zumindest einige cm, insbesondere zumindest 10 cm) und parallel zur Wärmequelle ausgerichtet, um eine Hitzebarriere innerhalb des Werkstückträgers auszubilden.

Vorzugsweise ist der Körper des Werkstückträgers zur Verbesserung der Stabilität und der Langlebigkeit getempert worden.

Nachfolgend wird die Erfindung anhand eines in den Zeichnungen gezeigten Ausführungsbeispiels näher erläutert. Die Zeichnungen zeigen schematisch in:
- Figur 1: einen Werkstückträger in perspektivischer Ansicht mit Blickrichtung auf die Unterseite des Werkstückträgers,
- Figur 2a, 2b: jeweils einen Werkstückträger im Querschnitt,
- Figur 3: einen Werkstückträger in perspektivischer Ansicht mit zwei Ausnehmung gen, mit welchen jeweils ein Werkstück bzw. eine Baugruppe aufgenommen werden kann,
- Figur 4a: einen Werkstückträger in einer perspektivischen Ansicht, wobei mit dünnen Linien im Inneren eines Hohlraums des Werkstückträgers enthaltene Versteifungsstrukturen Dargestellt sind, und
- Figur 4b: einen Schnitt dieses Werkstückträgers, wobei der Werkstückträger entlang einer horizontalen Ebene unterhalb einer oberen Abdeckung des Werkstückträgers geschnitten ist.

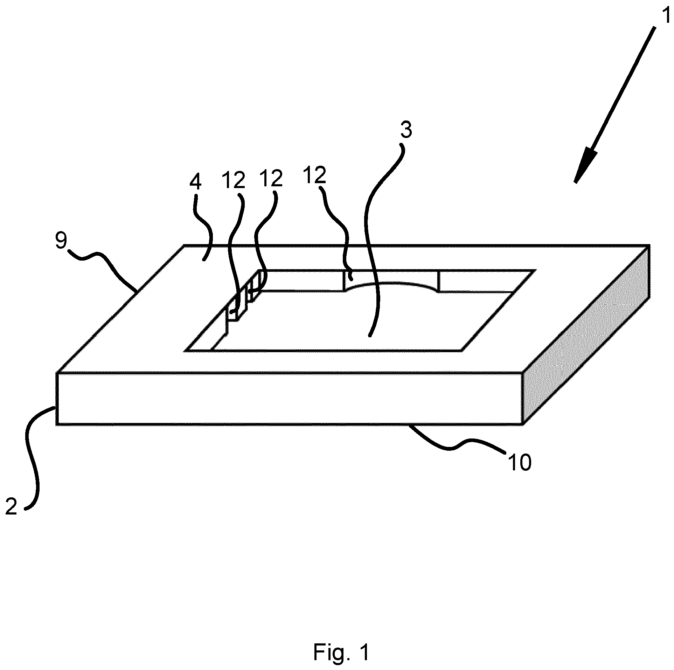

Die Erfindung kann mittels eines Werkstückträgers 1 ausgeführt werden, der einen Körper 2, welcher eine Ausnehmung 3 zur Aufnahme eines oder mehrerer Werkstücke umfasst, und eine Beschichtung 4 an der Unterseite aufweist (Figur 1). Die Ausnehmung 3 ist in den Figuren nur grob schematisch dargestellt und ist mit ihrem Rand komplementär zur Form einer Baugruppe ausgebildet, so dass diese darin rutschfest angeordnet werden kann und die zu lötenden Lötstellen im Bereich der Ausnehmung nach unten weisend angeordnet sind, so dass sie von unten frei zugänglich sind. Sie können daher mit Lot einer Lötwelle benetzt werden.

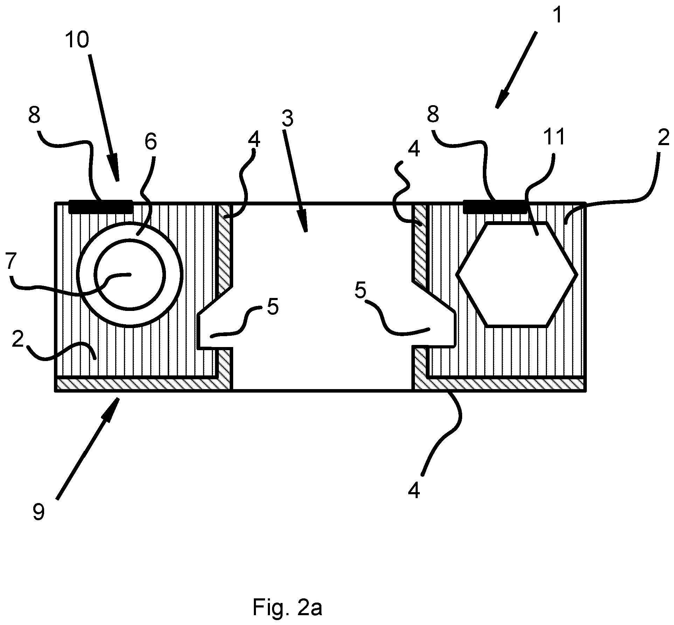

Der Werkstückträger 1 weist angrenzend zur Ausnehmung 3 Hinterschnitte 5 auf, um darin die Ränder einer Baugruppe aufzunehmen, welche aus einer flexiblen Leiterplatte besteht. Durch die Hinterschnitte 5 kann auch eine flexible Leiterplatte zuverlässig mit dem Werkstückträger gehalten werden. (Figur 2a)
Der Werkstückträger 1 ist weiterhin mit einem Hohlraum 6 versehen, in dem ein Schlauch eingeführt ist, der einen Kanal 7 zur Durchleitung von warmen und kalten Medien, bspw. Kühlfluiden oder Wärmemitteln ausbildet. Ist das Material des Köpers 2 dicht, dann kann der Hohlraum selbst unmittelbar als Kanal verwendet werden.

Im Werkstückträger 1 können Einlegeteile 8 vorgesehen sein. Diese Einlegeteile sind bspw. Verstärkungselemente, welche die mechanischen Eigenschaften des Werkstückträgers optimieren und diesen vor allem versteifen können. Die Einlegeteile 8 können auch Buchsen oder andere Funktionsteile sein.

Der Werkstückträger 1 weist eine Unterseite 9 und eine Oberseite 10 auf.

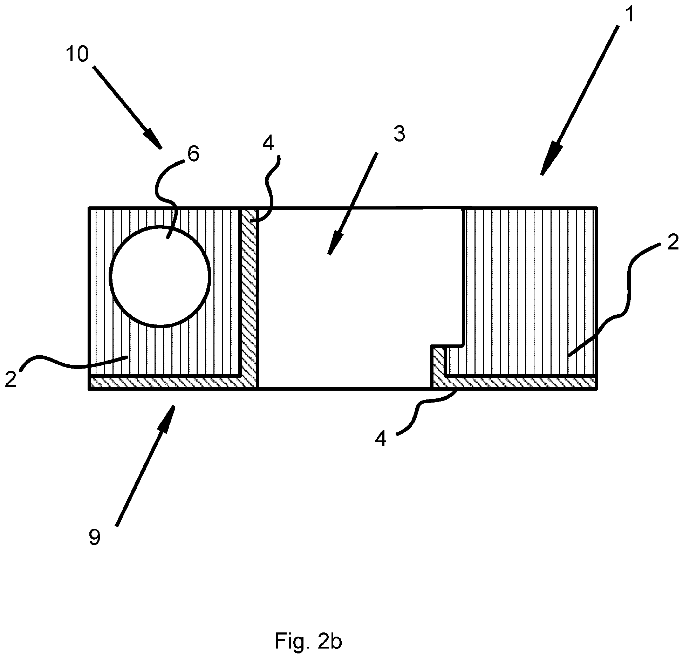

Im Werkstückträger 1 sind geschlossene Hohlräume 11 zur Reduzierung der Wärmekapazität im Körper 2 ausgebildet (Figur 2).

Die komplementär zur Baugruppe geformten Ausformungen 12 sind an deren Kontur angepasst. Daraus ergibt sich, dass die Lage des Werkstücks eindeutig bestimmbar ist. Eine Baugruppe kann passgenau in den Werkstückträger 1 von der Oberseite 10 her eingesetzt werden, damit die Baugruppe von der Unterseite 9 vorzugsweise in den Randbereichen der Baugruppe gestützt wird und dort prozessiert werden kann (Figur 1). Dadurch wird erreicht, dass die Baugruppe an allen Seiten auf den Ausformungen 12 aufliegt und ein Durchbiegen der Baugruppe verhindert wird. In Ausführungsformen ist es ebenfalls möglich die Ausformungen 12 derart auszubilden, dass bestimmte Randbereiche der Baugruppe freiliegen, sodass diese bestückbar sind.

Der Werkstückträger 1 kann auch angrenzend zur Ausnehmung 3 Hinterschnitte 5 aufweisen, um darin die Ränder einer Baugruppe aufzunehmen, welche aus einer starren Leiterplatte besteht. Durch die Hinterschnitte 5 kann auch eine starre Leiterplatte zuverlässig mit dem Werkstückträger gehalten werden. (Figur 2b)

Im vorliegenden Ausführungsbeispiel weist der Werkstückträger 1 einen Körper 2 mit einer Beschichtung 4 an der Unterseite 9 auf.

Im Folgenden wird die Unterseite 9 des Werkstückträgers 1 als die der Wärmequelle zugewandte Seite bezeichnet, während die Oberseite 10 des Werkstückträgers 1 die von der Wärmequelle abgewandte Seite beschreibt. Die Wärmequelle ist hierbei eine Wärmeübertragung durch Strahlung.

Bei Gebrauch wird ein Werkstück derart im Werkstückträger 1 positioniert, dass die darin angeordnete Baugruppe auf ihrer Unterseite prozessiert werden kann. Die Ausnehmung 3 erstreckt sich von der Oberseite 10 bis zur Unterseite 9 durch den Körper 2 hindurch.

Die Ausnehmung 3 ist zur Aufnahme eines oder mehrerer Werkstücke ausgebildet, sodass ein Werkstück vom Werkstückträger 1 gestützt und/oder gehalten wird. In Ausführungsformen kann ein Werkstückträger 1 auch mehrere Ausnehmungen aufweisen. Diese Ausnehmungen 3 können in einer Matrix angeordnet sein.

In Ausführungsformen können Hinterschnitte 5 auch dazu dienen, offene Ausnehmungen in den Körper 2 einzubringen, um das Gewicht und die Wärmekapazität zu reduzieren.

Es können auch geschlossene Hohlräume 11 zur Reduzierung der Wärmekapazität im Körper 2 ausgebildet sein. Diese Hohlräume 11 bewirken zudem eine hohe Stabilität bei einem geringen Gewicht und sind vorzugsweise paarweise auf gegenüberliegenden Bereichen des Werkstückträgers 1 angeordnet. Diese geschlossenen Hohlräume 11 können in verschiedenen Formen ausgestaltet sein, z.B. im Querschnitt sechseckig oder rund. In Ausführungsformen kann auch eine Vielzahl an Hohlräumen 11 im Körper 2 angeordnet sein.

Im vorliegenden Ausführungsbeispiel ist vorgesehen, dass der Körper 2 aus einem temperatursteifen Kunststoff ausgebildet ist, der einen Anteil an Carbonfasern zwischen 10 - 25 Gew.% aufweist. In Ausführungsformen kann der temperatursteife Kunststoff auch einen Anteil an Glasfasern enthalten.

Ein temperatursteifer Kunststoff für einen Werkstückträger behält bei einer Temperatur von zumindest 100°C für eine Dauer von etwa 30 min seine Stabilitätseigenschaften. Es ist auch möglich, dass ein temperatursteifer Kunststoff eingesetzt wird, welcher auch bei Temperaturen von zumindest 120°C und insbesondere von zumindest 130°C seine Stabilitätseigenschaften behält. Der Glasübergangspunkt des Kunststoffes liegt hierbei möglichst über der geforderten Mindesttemperatur.

Beispielsweise kann der temperatursteife Kunststoff Peek sein, der einen Glasübergangspunkt von etwa 150°C aufweist.

In Ausführungsformen kann der Kunststoff des Körpers 2 auch einen anders gewichteten Anteil an Carbon- und/oder Glasfasern zur Verbesserung der Stabilität ohne Erhöhung der Wärmeleitfähigkeit/Wärmekapazität aufweisen.

Der Körper 2 kann mittels 3D-Druck durch Materialextrusion (FDM) hergestellt worden. In alternativen Ausführungsformen kann der Körper 2 durch Binder-Jetting, Material-Jetting , VAT, Fotopolymerisation, selektives Laserschmelzen, Laser Power Bed Fusion, Laserauftragschweißen und/oder selektives Lasersintern hergestellt worden sein. Durch die Herstellung mittels 3D-Druck weist der Körper in einer weiteren Ausführungsform eine Wabenstruktur auf, die stabil ist und gleichzeitig eine Reduzierung der thermischen Masse zulässt.

In alternativen Ausführungsform sind mehrere Werkstückträger 1 in einem Rahmenelement angeordnet. Die einzelnen Werkstückträger werden in das Rahmenelement eingelegt und zusammen prozessiert. Das Rahmenelement ist vorzugsweise aus Aluminium, einem anderen Metall oder einem duroplastischen Kunststoff ausgebildet. Durch die Verwendung von Werkstückträgern in einem Rahmen ist es möglich einen Körper mit unterbrochenen Kanten zu realisieren, in dem die Träger beanstandet voneinander eingesezt werden.

Im vorliegenden Ausführungsbeispiel ist der Körper 2 nach dessen Herstellung im additiven Fertigungsverfahren mindestens einmal und vorzugsweise vor dem Beschichten getempert worden. Er kann nach dem Beschichten nochmals getempert oder ausschließlich nach dem Beschichten getempert werden. Es ist es auch möglich den Körper 2 ohne Tempern in Gebrauch zu nehmen.

Der Werkstückträger kann, wie oben erläutert, einen oder mehrere Kanäle 7 zur Durchleitung von warmen und kalten Medien (vor allem Kühlmedien) aufweisen. Es können nur bestimmte Abschnitte des Werkstückträgers oder auch der gesamte Träger gleichmäßig mit einem oder mehreren Kanälen durchzogen sein.

In Ausführungsformen kann der Körper 2 keinen Kanal 7 zur Durchleitung von warmen oder kalten Medien aufweisen.

Kalte Medien oder auch Kühlmedien sind zumeist Kühlfluide, wie z.B. kaltes Wasser, Druckluft oder ähnliches, die zur Wärmeaufnahme dienen.

Warme Medien weisen in der Regel ein Wärmemittel in Form eines Fluids auf und dienen zur Wärmeabgabe. Bspw. warme Luft, heißes Wasser oder dergleichen.

Es ist auch denkbar, dass die warmen und kalten Medien als warme oder kalte Metallstangen ausgebildet sind, welche in den Kanal 7 eingeführt werden.

Es ist vorgesehen, dass der Körper 2 mindestens einen Einlegeteil 8 zur Stabilisierung umfasst. Ein solches Einlegeteil kann sich auf die gesamte Größe des Werkstückträgers oder auch nur auf bestimmte besonders zu stabilisierende Bereiche erstrecken. Das Einlegeteil 8 ist vorzugsweise etwa parallel zur Oberseite 10 bzw. Unterseite 9 angeordnet, da es in der Regel ein guter Wärmeleiter ist und so sichergestellt wird, dass der Wärmefluss quer zur Ebene des Werkstückträgers gering ist. Es können auch mehrere Einlegeteile 8 in den Körper 2 eingebracht werden.

Ein Einlegeteil 8 kann eine eingezogene Carbonschnur sein, die ein Durchbiegen des Körpers 2 bei thermischer und/oder mechanischer Belastung verhindert. In Ausführungsformen können diese Einlegeteile 8 auch aus Metall, insbesondere Titan wegen seiner geeigneten thermischen Eigenschaften bspw. eine relativ niedrige Wärmeleitung gegenüber anderen Metallen, bestehen.

Im vorliegenden Ausführungsbeispiel ist die Wärmestrahlung reflektierende Beschichtung 4 zumindest auf der der Wärmequelle zugewandten Unterseite 9 angeordnet.

Die Wärmestrahlung reflektierende Beschichtung 4 umfasst elektrisch leitende Metallpartikel. Die Beschichtung 4 kann auf Basis eines geeigneten Bindemittels, beispielsweise Silikonharz, sein, welches Metallpartikel enthält. Weiterhin ist vorgesehen dass die Metallpartikel überwiegend aus Aluminium oder einer Aluminiumlegierung ausgebildet sind. In Ausführungsformen können die Metallpartikel die Metalle Gold, Silber, Nickel, Kupfer und/oder Chrom sowie Legierungen daraus umfassen.

Die Beschichtung 4 umfasst zumindest zwei Schichten, welche aufeinanderfolgend durch eine Düse aufgetragen worden sind. Es ist vorgesehen, dass die Schichten selbst sehr dünn ausgebildet sind. In Ausführungsformen ist es auch möglich, eine dickere Schicht aufzutragen, welche homogen ausgebildet ist.

Weiterhin ist vorgesehen, dass die Beschichtung 4 durch Tempern ausgehärtet worden ist. In alternativen Ausführungsformen kann die Beschichtung 4 auch selbst aushärtend sein und durch Licht und/oder chemische Behandlung ausgehärtet werden.

Im vorliegenden Ausführungsbeispiel wird der Werkstückträger 1 in einer Lötmaschine prozessiert. Dafür wird der Werkstückträger 1 mit zumindest einer Baugruppe per Hand oder mit einem Manipulator bestückt.

Eine Lötmaschine für Schwall- oder Wellenlöten weist einen Löttunnel, in dem eine Transporteinrichtung angeordnet ist, auf, mit welcher zu lötende Baugruppen in einen Werkstückträger 1 in Transportrichtung durch den Lötvorgang prozessiert werden können. Die Lötmaschine ist zumeist etwa horizontal liegend ausgebildet und weist zumindest einen der folgenden Abschnitte auf. Die Lötmaschine kann in Ausführungsformen auch zum Selektivlöten ausgebildet sein.

Der Werkstückträger 1 wird parallel zur Transportrichtung mit der Unterseite 9 in Richtung der Einrichtungen der Lötmaschine eingegeben. Im ersten Abschnitt wird Flussmittel in Richtung der Unterseite des Werkstückträgers auf die Baugruppe durch einen Fluxer aufgebracht. Danach werden das Werkstück und der Werkstückträger durch einen Heizstrahler erwärmt. Diesen Vorgang bezeichnet man auch als Vorheizen. Im dritten Abschnitt wird der Werkstückträger 1 zusammen mit der Baugruppe über eine Lötwelle transportiert. Die Lötstellen, die auf der Unterseite der Baugruppe angeordnet sind, werden mit Lot benetzt und dadurch ausgebildet. In die Lötmaschine ist vorzugsweise ein temperaturgeregelter Kühlabschnitt integriert. Die Kühlung erfolgt passiv durch Konvektion. Dadurch können Baugruppe sowie Werkstückträger 1 gezielt abgekühlt werden und sind somit schneller für die weitere Produktion verfügbar.

In Ausführungsformen kann ein Werkstückträger 1 auch in anderen Lötverfahren eingesetzt werden, z. B. Selektiv - oder Reflowlöten. Ebenso können sich die Abschnitte der Lötmaschine, in denen der Werkstückträger 1 prozessiert wird, von denen im oben genannten Ausführungsbeispiel in ihrer Art, Anzahl und/oder ihrer Reihenfolge unterscheiden.

In alternativen Ausführungsformen kann eine Lötmaschine auch weitere Prozessschritte wie Nutzentrennen, Fräsen, Lackieren, Aushärten, Einpress- oder Schraubverfahren, elektrische/mechanische/optische/Röntgen- Prüfungen und/oder Reinigungsverfahren umfassen. Die Baugruppe kann auch außerhalb der Lötmaschine für bspw. diese Prozessschritte zusammen mit dem Werkstückträger 1 durchlaufen.

In den Werkstückträgern 1 können in der Lötmaschine durch die Kanäle 7 aktiv mittels einer Pumpe Kühlmedium geleitet werden. In alternativen Ausführungsformen kann auch ein warmes Medium zur Vorheizung in die Kanäle 7 eingeleitet werden. Es kann auch während der Prozessierung durch die Lötmaschine zwischen warmem und kaltem Medium abgewechselt werden.

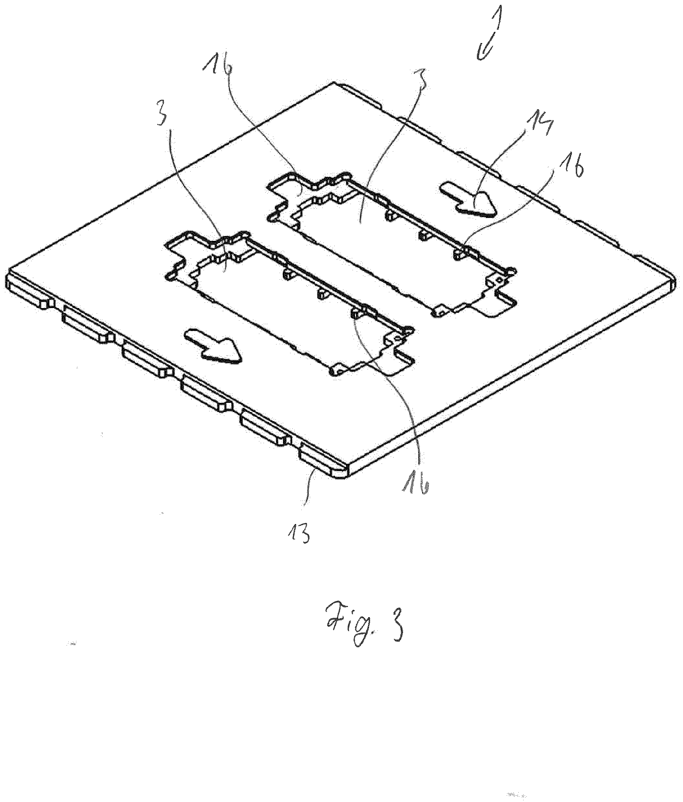

Ein weiteres Ausführungsbeispiel eines erfindungsgemäßen Werkstückträgers 1 (Figur 3) weist zwei Ausnehmungen 3 auf, mit welchen jeweils ein Werkstück bzw. eine Baugruppe aufgenommen werden kann. Dieser Werkstückträger ist, sofern nachfolgend nichts anderes erläutert ist, genauso wie das oben beschriebene Ausführungsbeispiel aus einem temperatursteifen Kunststoff mit einer Wärmestrahlung reflektierenden Beschichtung an der Unterseite ausgebildet.

Der Werkstückträger 1 weist an seinen Längsseiten, welche parallel zur Transportrichtung Pfeil 14 verlaufen, Leisten 13 zur Positionierung des Werkstückträgers 1 in einer Transporteinrichtung 2 auf. Die Leisten 13 sind aus mehreren voneinander getrennten Segmenten 15 ausgebildet, wobei die Segmente zueinander mit Abstand angeordnet sind. Die Leisten 13 sind in der Regel als Vollkörper ausgebildet, wodurch es bei Temperatureinwirkungen zu Verzügen kommen kann. Durch die Unterbrechung der Leiste in mehrere Segmente 15 wird die Gefahr von derartigen Verzügen bei Temperatureinwirkungen erheblich verringert.

An der Ausnehmung 3 sind nach innen vorragende Vorsprünge 16 zum Stützen der zu bearbeitenden Baugruppen vorgesehen. Die Vorsprünge 16 sind an Stellen angeordnet, an welchen sie nicht mit zu lötenden Kontaktstellen der Baugruppe kollidieren. Auch diese Vorsprünge 16 sind in der Regel als Vollkörper ausgebildet und vorzugsweise in mehrere Segmente unterteilt, um die Gefahr eines Verzugs gering zu halten.

Transporteinrichtungen weisen Aufnahmeelemente auf, in welche die Leisten 13 eingesetzt werden. Diese Aufnahmeelemente sind üblicherweise auf eine maximale Höhe von 6 mm begrenzt. Dadurch sollten für derartige standardisierte Transporteinrichtungen die Randleisten 13 nicht höher als 6 mm sein.

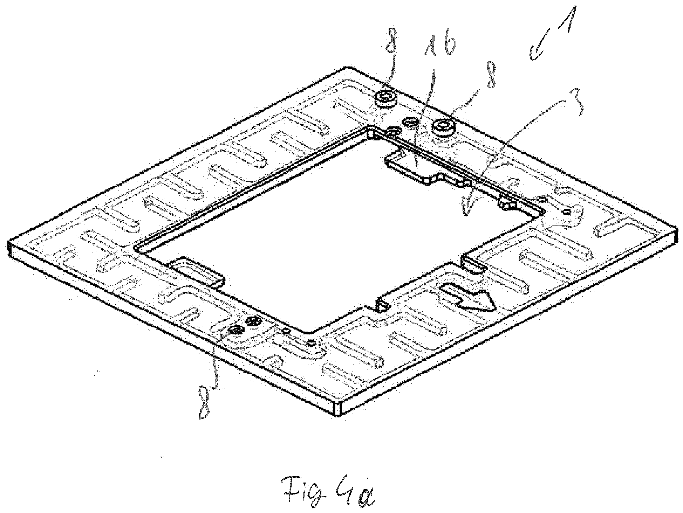

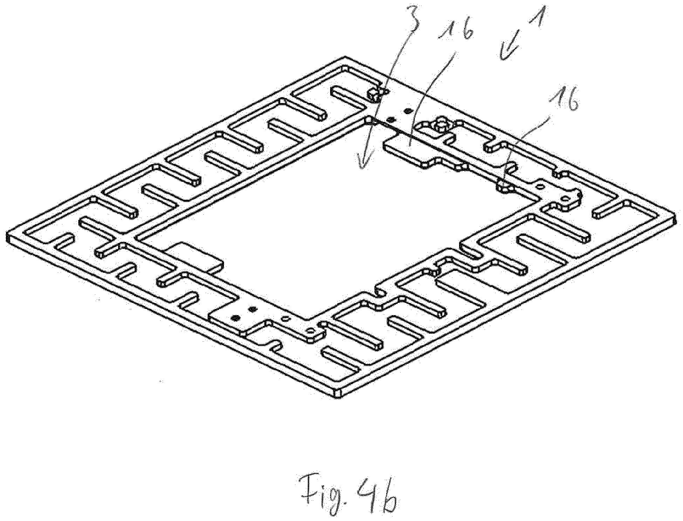

Ein weiteres Ausführungsbeispiel eines Werkstückträgers 1 ist in Figur 4a und 4b gezeigt. Dieser Werkstückträger ist genauso wie die oben erläuterten Ausführungsbeispiele aus einen temperatursteifen Kunststoff ausgebildet, wobei der Werkstückträger an seiner Unterseite mit einer Wärmestrahlung reflektierenden Beschichtung versehen ist. Sofern nachfolgend nichts anderes erläutert ist, gelten die Ausführungen zum ersten Ausführungsbeispiel gleichermaßen für das Ausführungsbeispiel gemäß Figur 4a, 4b.

Dieser Werkstückträger 1 bildet in der Draufsicht einen etwa rechteckförmigen Rahmen, wobei die einzelnen Rahmenelemente als Hohlkörper ausgebildet sind. Figur 4a zeigt den Werkstückträger in einer perspektivischen Ansicht, wobei mit dünnen Linien im Hohlraum des Werkstückträgers enthaltene Versteifungsstrukturen dargestellt sind. Figur 4b zeigt einen Schnitt dieses Werkstückträgers, wobei der Werkstückträger entlang einer horizontalen Ebene unterhalb einer oberen Abdeckung des Werkstückträgers geschnitten ist.

Im Rahmen der Erfindung können die Werkstückträger in vielfältiger Weise variiert werden. Oben sind Ausführungsbeispiele gezeigt, die jeweils einen Werkstückträger zur Aufnahme einer oder mehrerer Baugruppen zeigen, die unmittelbar in eine Transporteinrichtung einer Lötmaschine eingesetzt werden können. So können die Werkstückträger beispielsweise mit einer Wabenstruktur ausgebildet sein. Vorzugsweise ist die am Werkstückträger ausgebildete Kontur zur Aufnahme der Baugruppen so geformt, dass die Baugruppe nur in einer bestimmten Position an dem Werkstückträger angeordnet werden kann. Hierzu kann beispielsweise ein stiftförmiger Vorsprung am Werkstückträger ausgebildet sein, der in eine korrespondierende Öffnung der Baugruppe eingreifen kann.

### Bezugszeichenliste

- 1: Werkstückträger
- 2: Körper des Werkstückträgers
- 3: Ausnehmung für ein oder mehrere Werkstücke
- 4: Wärmestrahlung reflektierende Beschichtung
- 5: Hinterschnitte
- 6: geschlossener Hohlraum
- 7: Kanal
- 8: Einlegeteil
- 9: Unterseite
- 10: Oberseite
- 11: Hohlraum zur Gewichtsreduktion
- 12: komplementäre Ausformungen zur Baugruppe
- 13: Leisten
- 14: Pfeil
- 15: Segment
- 16: Vorsprung

## Patentansprüche

1. Werkstückträger (1) zur Positionierung von Werkstücken auf einer Transporteinrichtung in einer Lötmaschine,
wobei der Werkstückträger einen Körper (2) aus einem Kunststoff aufweist,
**dadurch gekennzeichnet,**
**dass** der Körper (2) des Werksstückträgers (1) mittels einem additiven Fertigungsverfahren hergestellt ist und der Werkstückträger (1) eine Wärmestrahlung reflektierende Beschichtung (4) aufweist.

2. Werkstückträger nach Anspruch 1,
**dadurch gekennzeichnet,**
**dass** der Werkstückträger (1) Hinterschnitte (5) oder geschlossene Hohlräume (6) zur Reduzierung der thermischen Masse aufweist.

3. Werkstückträger nach Anspruch 1 oder 2,
**dadurch gekennzeichnet,**
**dass** zumindest an einem Randbereich des Werkstückträgers (1) eine Leiste (13) zur Positionierung in einer Transporteinrichtung angeordnet ist.

4. Werkstückträger nach einem der vorherigen Ansprüche ,
**dadurch gekennzeichnet,**
**dass** die Beschichtung (4) elektrisch leitende Metallpartikel zur Ableitung elektrostatischer Aufladung umfasst.

5. Werkstückträger nach einem der vorherigen Ansprüche,
**dadurch gekennzeichnet,**
**dass** der Körper (2) des Werkstückträgers (1) aus einem thermoplastischen Kunststoff her gestellt ist, der dann durch chemische Behandlung oder Strahlungseinwirkung in einen duroplastischen Kunststoff umgewandelt wird.

6. Werkstückträger nach einem der vorherigen Ansprüche,
**dadurch gekennzeichnet,**
**dass** der Kunststoff des Körpers (2) Carbon- oder Glasfasern umfasst.

7. Werkstückträger nach einem der vorherigen Ansprüche,
**dadurch gekennzeichnet,**
**dass** der Kunststoff einen Anteil von Carbonfasern zwischen 10 - 25 % aufweist.

8. Werkstückträger nach einem der vorherigen Ansprüche,
**dadurch gekennzeichnet,**
**dass** der Werkstückträger (1) getempert worden ist.

9. Werkstückträger nach einem der vorherigen Ansprüche,
**dadurch gekennzeichnet,**
**dass** der Werkstückträger (1) Kanäle (7) zur Durchleitung eines kalten oder warmen Medi ums umfasst.

10. Werkstückträger nach einem der vorherigen Ansprüche1,
**dadurch gekennzeichnet,**
**dass** Einlegeteile (8) in den Werkstückträger eingebracht werden können.

11. Werkstückträger nach einem der vorherigen Ansprüche,
**dadurch gekennzeichnet,**
**dass** die Beschichtung (4) mehrere Schichten aufweist.

12. Werkstückträger nach einem der vorherigen Ansprüche,
**dadurch gekennzeichnet,**
**dass** die Beschichtung (4) durch Tempern ausgehärtet worden ist.

13. Werkstückträger nach einem der vorherigen Ansprüche,
**dadurch gekennzeichnet,**
**dass** die Beschichtung (4) Wärmestrahlung reflektierende Partikel umfasst, insbesondere Chrom-, Aluminium-, Gold-, Silber-, Nickel und/oder Kupferpartikel.

14. Werkstückträger nach einem der vorherigen Ansprüche,
**dadurch gekennzeichnet,**
**dass** der Werkstückträger aus einem temperatursteifen Kunststoff ausgebildet ist.
